# EUROPEAN PATENT APPLICATION

(11) **EP 1 310 992 A1**
(43) Date of publication of application: **14.05.2003**
(21) Application number: 01938634.1
(22) Date of filing: 13.06.2001
(51) Int. Cl.: H01L 21/60, H01B 5/16, H01B 3/00, H01R 11/01

(54) **MICROPARTICLE ARRANGEMENT FILM, ELECTRICAL CONNECTION FILM, ELECTRICAL CONNECTION STRUCTURE, AND MICROPARTICLE ARRANGEMENT METHOD**

(30) Priority: 14.06.2000 JP 2000178716
(71) Applicant: SEKISUI CHEMICAL CO., LTD., Osaka-shi, Osaka 530-8565 (JP)
(72) Inventor: SUZUKI, Tatsuo, c/o Sekisui Chemical Co. Ltd., Osaka-shi, Osaka 530-8565 (JP); FUKUOKA, Masateru, c/o Sekisui Chemical Co., Ltd., Mishima-gun, Osaka 618-8589 (JP); IUCHI, Kenji, c/o Sekisui Chemical Co., Ltd., Mishima-gun, Osaka 618-8589 (JP)
(74) Representative: Hubert, Philippe
(86) International application number: JP0105014
(87) International publication number: WO01097276

(57) **Abstract**

The present invention provides a method for disposing specific fine particles at arbitrary positions of a film with efficiency and ease, in just proportion and under a stable condition, and a fine particle-disposed film, that is to say, a method for disposing fine particles that basically disposes one particle in one hole, and fine particle-disposed film, as well as a conductively connecting film and a conductively connected structure, when opposite fine electrodes are connected, enabling to carry out easily an electric connection of high connecting reliability in a short time without causing leakage from neighbor electrodes by employing a film in which conductive fine particles are disposed at arbitrary positions thereof.

The invention is a fine particle-disposed film, in which fine particles are disposed, the fine particles each having: an average particle diameter of 5 to 800 µm; an aspect ratio of less than 1.5; and CV value of 10% or less, wherein the film has holes at arbitrary positions in a surface thereof, the holes each having: an average hole diameter which is 1/2 to 2 times of the average particle diameter of the fine particle; the aspect ratio of less than 2; and the CV value of 20% or less, and the fine particles are disposed on the surface of the holes or inside the holes.

## Description

### TECHNICAL FIELD

The present invention relates to a fine particle-disposed film in which specific fine particles are disposed in the film, a conductively connecting film and a conductively connected structure, which are used to an electric connection between fine electrodes, and a method for disposing fine particles.

### PRIOR ART

Conventionally, as methods of disposing fine particles at specific positions of a film, there have been used a method of mechanically placing individual particles on the film, a method of transferring previously disposed particles to the film, a method of coating an adhesive or the like at the specific positions of the film and scattering fine particles to adhere thereon, further a method of dispersing fine particles in a paste to coat them, and the others.

However, these methods have inconveniences that a disposing efficiency is inferior, a process is troublesome, fine particles are placed more than necessarily, reversely fine particles are not disposed at requiring positions and so on.

Besides, with respect to electronic products such as a liquid crystal display, a personal computer, or mobile communication machines, in methods of electrically connecting small sized parts as a semiconductor element on a substrate, or electrically connecting substrates each other, there are methods of opposite fine electrodes to connect by connecting with a solder or a conductive paste by using metal bumps or the like, or directly press-attaching metal bumps.

In the case of connecting fine opposite electrodes, because of a problem such as a weak strength in individual connecting portions, it is generally necessary to seal the neighborhood therearound with a resin. This sealing is ordinarily made by pouring the sealing resin after having connected the electrodes. But the opposite fine electrodes have short distance at the connections, and so it is difficult to uniformly pour the sealing resin in a short time.

For settling these inconveniences, an anisotropic conductive adhesive may be assumed, in which conductive fine particles are mixed with a binder resin to make a film or paste shaped, and it is disclosed in Japanese Kokai Publication Sho-63-231889, Japanese Kokai Publication Hei-04-259766, Japanese Kokai Publication Hei-03-291807, Japanese Kokai Publication Hei-05-75250, and so forth.

However, since the anisotropic conductive adhesive generally comprises the conductive fine particles dispersed at random in an insulating adhesive, the conductive fine particles are combined in a binder, or fine particles absent on the electrodes flow and are combined when heated and press-attached, whereby it is possibility to cause a leakage at neighbor electrodes. In addition, even if fine particles are pressed on electrodes or bumps by heating and press-attaching, since a thin layer of an insulating material easily remains between the electrode and the fine particle, there occurs a problem of lowering a connecting reliability.

### SUMMARY OF THE INVENTION

It is accordingly an object of the invention to provide a method for disposing specific fine particles at arbitrary positions of a film with efficiency and ease, in just proportion and under a stable condition, and a fine particle-disposed film, that is to say, a method for disposing fine particles that basically disposes one particle in one hole, and fine particle-disposed film, as well as a conductively connecting film and a conductively connected structure, when opposite fine electrodes are connected, enabling to carry out easily an electric connection of high connecting reliability in a short time without causing leakage from neighbor electrodes by employing a film in which conductive fine particles are disposed at arbitrary positions thereof.

The invention is a fine particle-disposed film, in which fine particles are disposed, the fine particles each having:
an average particle diameter of 5 to 800 µm;
an aspect ratio of less than 1.5; and
CV value of 10% or less,
   wherein the film has holes at arbitrary positions in a surface thereof, the holes each having: an average hole diameter which is 1/2 to 2 times of the average particle diameter of the fine particle; the aspect ratio of less than 2; and the CV value of 20% or less, and
the fine particles are disposed on the surface of the holes or inside the holes.

It is preferable that the fine particle is a spherical particle having: an average particle diameter of 20 to 150 µm; an aspect ratio of less than 1.1; and a CV value of 2% or less. It is preferable that the fine particle has: K value of 400 to 15000 N/mm²; a recovery rate of 5% or more; and a coefficient of linear expansion at normal temperature of 10 to 200 ppm, and more preferable that the fine particle has: K value of 2000 to 8000 N/mm²; a recovery rate of 50% or more; and coefficient of linear expansion at normal temperature of 30 to 100 ppm. Preferably, a core of the fine particle is a high-molecular-weight material, and the fine particle has a metal coating layer. In the case of the fine particle having the metal coating layer, the metal coating layer has preferably a thickness of 0.3 µm or more, and the metal preferably contains nickel or gold. Further, In the case of serving the fine particle-disposed film according to the invention as a conductively connecting film, the fine particle is preferably a conductive fine particle having a resistance value of 3 Q or less, more preferably 0.05 Ω or less. A conductively connected structure obtained by connecting the conductively connecting film is also one of the aspects of the invention.

A film for use in the fine particle-disposed film of the invention has preferably a thickness of 1/2 to 2 times of the average particle diameter of the fine particle, more preferably 3/4 to 1.3 times. A Young's modulus of the film surface is preferably 10 GPa or less. It is preferable that the film has a property of adhering by pressing or heating, and a property of curing by heating or UV irradiation. In the case the film has the curing property, preferably the coefficient of linear expansion after curing is 10 to 200 ppm.

It is preferable that the hole has an average hole diameter of 4/5 to 1.3 times of the average particle diameter of the fine particle, the CV value is 5% or less, the aspect ratio is less than 1.3, and further, the hole is tapered or step-wise in the thickness direction. In this case, preferably the average hole diameter of the film back side is not more than the average hole diameter of the film front side, and is 50% or more of the average hole diameter of the film front side, and more preferably the average hole diameter of the film back side is not more than the average hole diameter of the film front side, and is 80% or more of the average hole diameter of the film front side. The hole is preferably processed by means of a laser.

The fine particle-disposed film of the invention may be provided by a fine particle-disposing method of sucking the fine particles in from the film back side having substantially no tuck on the surface. In this case, the suction of the fine particles is carried out by a suction of gas,
when the average particle diameter of the fine particles is 800 to 200 µm, a degree of vacuum in the suction side is preferably -10 kPa or less,
when the average particle diameter of the fine particles is 200 to 40 µm, a degree of vacuum in the suction side is preferably -20 kPa or less, and
when the average particle diameter of the fine particles is less than 40 µm, a degree of vacuum in the suction side is preferably -30 kPa or less.

In addition, a suction opening is preferably provided with a support plate when the fine particles are sucked in. It-is preferable that the disposing method includes a step of removing extra adhering particles with an air purge or a brush, a step of pressing the fine particle-disposed film, and a center of gravity of the fine particle reside inside the film and the fine particles are disposed with electricity being removed.

### BRIEF DESCRIPTION OF THE DRAWING

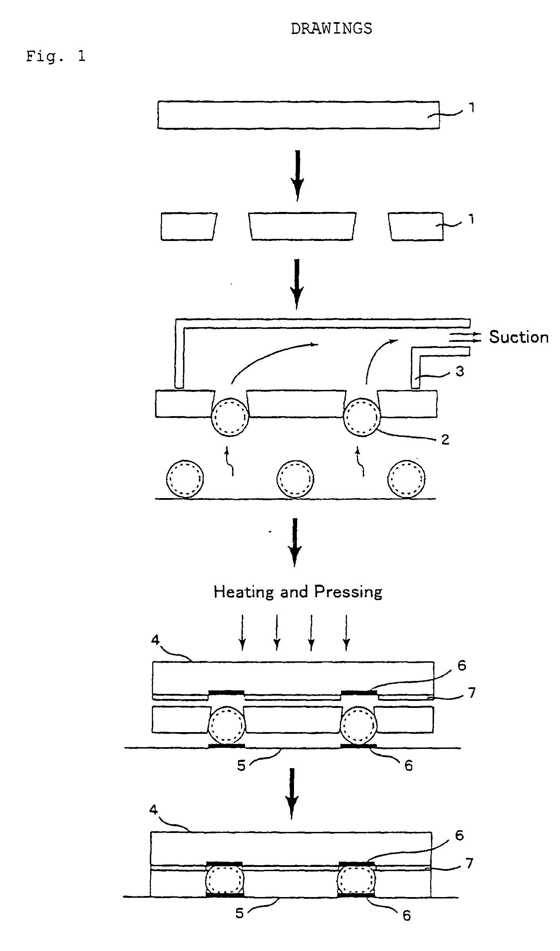

Fig. 1 is a diagram illustrating one embodiment of a process of making the conductively connected structure according to the invention.

In the Fig. 1, reference numeral 1 is the film, 2 is conductive fine particles, 3 is the suction opening, 4 is IC, 5 is the substrate, 6 is electrodes, and 7 is a protective film.

### DETAILED DESCRIPTION OF THE INVENTION

The invention will be explained in detail as follows.

The average particle diameters of the fine particles are 5 to 800 µm.

The average particle diameters may be obtained by observing 100 particles of arbitrary fine particles through a microscope. In the case of the average particle diameter being less than 5 µm, the fine particles cannot be substantially disposed in the holes, because absorption of the particles is difficult, the fine particles are adhered or causes aggregation by static electricity or the like. If the diameter is more than 800 µm, those can be disposed even by known methods without inconvenience.

If the fine particle-disposed film of the invention is used as the conductively connecting film, in the case of the average particle diameter being less than 5 µm, because of problems about precision of smoothness in the electrodes or substrates, particles do not contact the electrodes and possibly causes bad conductivity, and while if said diameter is more than 800 µm, the particles cannot be in response to electrodes of fine pitches and generate a short circuit between neighbor electrodes.

The average particle diameters of the fine particles are preferably 10 to 300 µm, more preferably 20 to 150 µm, and still more preferably 40 to 80 µm.

The aspect ratio of those fine particles is less than 1.5.

The aspect ratio is a value obtained by dividing an average long diameter with an average short diameter of the particle, and if the aspect ratio is more than 1.5, the particles are irregular, and therefore those are deviated from the holes of the film or much clogged therein. If the fine particle-disposed film of the invention is used as the conductively connecting film, parts of short diameter do not reach the electrodes to cause a connection failure.

The aspect ratio is preferably less than 1.3, more preferably less than 1.1, and being less than 1.05, an effect remarkably goes up.

Since there are much fine particles of the aspect ratio being high, though it depends on producing methods, the fine particles used to the invention are desirably made globular under a deformable condition via methods such as making use of surface tension, to form a spherical particle.

The CV value of the fine particle is 10% or less.

The CV value is expressed with (σ/Dn) x 100% (σ is a standard deviation of the particle diameter, and Dn is a number average particle diameter). Since the particle diameters are irregular if the CV value exceeds 10%, large particles are off from the holes or many small particles are clogged into them. If the fine particle-disposed film of the invention is used as the conductively connecting film, in the case the CV value exceeds 10%, small particles do not reach to cause the connection failure.

The CV value is preferably 5% or less, more preferably 2% or less, and being less than 1%, an effect remarkably goes up.

Since normal fine particles have large CV values, the fine particles for the invention should be made regular in particle diameter e.g., by classification. In particular, it is difficult to precisely classify particles having diameter of 200 µm or less, and combinations with screening, air-or wet-classifications and the like are desirable. As to the fine particles, above all, preferable are spherical particles having average diameter of 20 to 150 µm, the aspect ratio of less than 1.1 and the CV value of 2% or less.

As the fine particles for the invention, for example, high-molecular-weight materials, inorganic substances such as silica, alumina, metals or carbon, compounds of lower molecular weight and the like may be employed, but in view of a moderate elasticity, a flexibility and a recovery rate and in view that globular substances are easily available, it is preferable that the high-molecular-weight material is used as a core.

As the high-molecular-weight materials, for example there are enumerated thermoplastic resins such as phenol resin, amino resin, acrylic resin, ethylene-vinyl acetate resin, styrene-butadiene block copolymer, polyester resin, urea resin, melamine resin, alkyd resin, polyimide resin, urethane resin, or epoxy resin; curable resin, crosslinking resin, or organic-inorganic hybrid polymers. Among them, from the viewpoint of heat resistance, the crosslinking resin is preferable. In addition, fillers may be contained as needed.

As the fine particle is demanded to have mechanical characteristics, desirably the K value is 400 to 15000 N/mm², the recovery rate is 5% or more and the coefficient of linear expansion at normal temperature is 10 to 200 ppm.

The K value of the fine particle is preferably 400 to 15000 N/mm². Herein, the K value is expressed with (3/√2) ·F·S^{-3/2}· R^{-1/2}, wherein F is a load value (N) under 10% compression deformation at 20°C, S is a value expressed with compression displacement (mm), and R is a value expressed with radius (mm). If the K value is less than 400, the fine particles cannot sufficiently bite into the opposite electrodes, and therefore conductivity is not probably provided, for example, when the electrode is oxidized on the surface or the like, or contacting resistance is large so that conductive reliability might go down. If the K value is more than 15000, when the fine particles are held between the opposite electrodes, excessive pressure is effected locally on the electrodes so that an element is might be broken, or gaps between the electrodes are decided with only particles of large diameter, and particles of small diameter do not reach the electrodes to probably cause the connection failure.

Thus, the K value is preferably 1000 to 10000, more preferably 2000 to 8000, and still more preferably 3000 to 6000.

The fine particle used to the invention has preferably the recovery rate of 5% or more at 20°C and under the 10% compression deformation. In the case that the recovery rate is less than 5%, if the opposite electrodes are instantaneously widened, e.g., by an impact or the like, the particle cannot follow it and an electric connection is made unstable in a moment. The recovery rate is preferably 20% or more, more preferably 50% or more, and being 80% or more, a remarkable effect is brought about.

The fine particle used to the invention has preferably the coefficient of linear expansion of 10 to 200 ppm at normal temperature. If the coefficient of linear expansion is less than 10 ppm, since difference in a linear expansion between the fine particle and the film is so large that, for example, in the case that a thermal cycle is effected or the like, the particle cannot follow expansion of the film and the electric connection might be made unstable. Reversely, if the coefficient of linear expansion is more than 200 ppm, for example, in the case that the thermal cycle is effected or the like, the distance between the electrodes is too much widened, and if the film is connected with the substrate, the connected part is broken and stress is concentrated to the connection of the electrodes to cause the connection failure.

The coefficient of linear expansion is preferably 20 to 150 ppm, and more preferably 30 to 100 ppm.

As the fine particle, more desirably the K value is 2000 to 8000 N/mm², the recovery rate is 50% or more and the coefficient of linear expansion at normal temperature is 30 to 100 ppm.

In the case that the fine particle-disposed film of the invention is used as the conductively connecting film, the fine particle must be the conductive fine particle. As the conductive fine particle, suitably used are those provided with a high-molecular-weight material as a core and a metal coating layer as the conductive layer coated over the core. Any limitation is not especially made to the metal, but those containing nickel or gold are recommended. From viewpoint of contacting resistance, conductivity with the electrode, and causing no oxidation deterioration, the surface layer is desirably gold, and the conductive fine particle has preferably a barrier layer for making multi-layer or a nickel layer for improving adhesion of the core and the metal.

The thickness of the metal coating layer is preferably 0.3 µm or more. If it is less than 0.3 µm, the metal coating layer might peel off when dealt with the conductive fine particles. In the case that the fine particle-disposed film of the invention is used as the conductively connecting film, there probably occur such cases that the enough conductivity is not provided or the metal covering film is broken when the fine particle-disposed film is pressed to connect the opposite electrodes, as a result, to cause connection failure. More preferable is 1.0 µm or more, and still more preferable is 2.0 µm or more. On the other hand, it is preferable that the thickness of the metal coating layer is 1/5 or less of the particle diameter so that properties of the high-molecular-weight material being the core are not lost.

As to the conductive resistance of the conductive fine particle, when it is compressed 10% of the average particle diameter, the conductive resistance of a single particle, that is, the resistance value is desirably 3 Q or less. If the conductive resistance exceeds 3 Q, a sufficient current value cannot be probably secured, or the conductive resistance cannot stand against large voltage and the element does not normally work.

The conductive resistance is desirably 0.3Ω or less, more desirably 0.5 Ω or less, and being 0.01 Ω or less, effects are considerably heightened that the particle is responsible to an element of a current driving type with keeping high reliability.

As the film for the fine particle-disposed film of the invention, for example, high-molecular-weight materials or composites thereof, inorganic substances such as ceramics, metals or carbon, compounds of lower molecular weight and the like may be employed, but in view that those compounds are easily available having moderate elasticity, flexibility and recovery rate, the high-molecular-weight materials or compounds thereof are preferable.

As the high-molecular-weight materials, for example there are enumerated thermoplastic resins such as phenol resin, amino resin, acrylicresin,ethylene-vinylacetate resin, styrene-butadiene block copolymer, polyester resin, urea resin, melamine resin, alkyd resin, polyimide resin, urethane resin, or epoxy resin; curable resin, crosslinking resin, organic-inorganic hybrid polymers and the like. Among them, from the viewpoint of ready ability of a material having less impurities and wide physical properties, epoxy based resins are desirable. The epoxy based resins contain a non-cured epoxy, mixture with the above mentioned resins or a half-cured epoxy. Inorganic fillers such as glass fibers or alumina particles may be contained as needed.

The thickness of the film is desirably 1/2 to 2 times of the average particle diameter of the fine particles. If it is less than 1/2 times, the disposed particles are ready for deviating from the holes. When the fine particle-disposed film of the invention is used as the conductively connecting film, the portion of the film cannot easily support the substrate. If the thickness exceeds 2 times, extra particles are easy to go into the holes. Further, when the fine particle-disposed film of the invention is used as the conductively connecting film, the fine particles do not reach the electrodes and cause the connection failure. The thickness of the film is desirably 2/3 to 1.5 times of the average particle diameter of the fine particles, more desirably 3/4 to 1.3 times, and being 0.8 to 1.2 times, a considerable effect is brought about. Still desirable is 0.9 to 1.1 times.

In particular, In the case that the fine particle-disposed film of the invention is used as the conductively connecting film, when a bump is present on the electrodes of the element or the substrate, the thickness of the film is desirably 1 time or more of the average particle diameter, and reversely when the bump is absent, the thickness of the film is desirably 1 time or less thereof.

The film has desirably a Young's modulus of the surface being 10 GPa or less. If the Young's modulus exceeds this value, the fine particle might be damaged or spring off when an external force is applied. The Young's modulus is preferably 2 GPa or less, and being 0.5 GPa or less, a remarkable effect is available.

The film used to the invention has desirably an adhesive property by pressing or heating. In particular, in the case that the fine particle-disposed film of the invention is used as the conductively connecting film, if alignment between the electrodes of the element and the substrate and the conductive fine particle of the film are made, the connection may be provided only by pressing or heating.

Further, the film used to the invention is preferably cured by heating or UV irradiation, thereby it is enabled to provide breakthrough reliability at the connecting parts.

These adhering and curing functions may be also obtained by coating a curable adhesive separately, but if the film itself has these functions, the producing process of the fine particle-disposed film of the invention can be very much simplified.

As to the film used to the invention, the coefficient of linear expansion at normal temperature after having cured is preferably 10 to 200 ppm. If the coefficient of linear expansion is less than 10 ppm, difference in the linear expansion between the film and the fine particle is large, and if this film is used as the conductively connecting film, for example, in the case that the thermal cycle is effected or the like, the film cannot follow expansion of the fine particle, and the electric connection may be made unstable. Reversely, if the coefficient of linear expansion exceeds 200 ppm, the distance between the electrodes is too widened, for example, in the case that the thermal cycle is effected or the like, and the fine particles separate from the electrodes to cause the connection failure. The coefficient of linear expansion is preferably 20 to 150 ppm, and more preferably 30 to 100 ppm.

The fine particle-disposed film of the invention is formed with holes having the average hole diameter being 1/2 to 2 times of the average particle diameter of the fine particles, the aspect ratio being less than 2, and the CV value being 20% or less at arbitrary positions of the film surface, and the fine particles are disposed on the surface of the hole or inside the hole.

The average hole diameter of the hole is 1/2 to 2 times of the average particle diameter of the fine particles. If said diameter is less than 1/2 times, the disposed particles are ready for deviating from the holes. When the fine particle-disposed film of the invention is used as the conductively connecting film, the fine particles are difficult to come out from the back side, and so the particles do not reach the electrodes to cause the connection failure. Revesely, if said diameter exceeds 2 times, extra particles are easy to go into the holes or go through the film and drop. The average hole diameter is preferably 2/3 to 1.5 times of the average particle diameter of the fine particles, more preferably 4/5 to 1.3 times, still more preferably 0.9 to 1.2 times, especially preferably 0.95 to 1.1 times, and most preferably 1 to 1.05 times.

The aspect ratio of the holes is less than 2. Here, the aspect ratio of the hole is meant by a value of dividing the average long diameter with the average small diameter. If the aspect ratio is not less than 2, the fine particle is off from the hole of the film or much fine particles are clogged in the holes. In the case that the fine particle-disposed film of the invention is used as the conductively connecting film, the fine particles do not reach the electrodes to cause the connection failure. The aspect ratio is preferably 1 . 5 or less, more preferably 1.3 or less, and still more preferably 1.1 or less.

The CV value of the hole is 20% or less. Here, the CV value of the hole is expressed with (σ2/Dn2) x 100% (σ2 is a standard deviation of the hole diameter, and Dn2 is the average hole diameter). If the CV value of the hole exceeds 20%, the hole sizes are irregular, and so particles are off from the small holes or many particles are clogged in large holes or penetrate through them. If the fine particle-disposed film of the invention is used as the conductively connecting film, particles do not reach to cause the connection failure. The CV value of the holes is preferably 10% or less, more preferably 5% or less, and being 2% or less, the effect remarkably goes up.

The average hole diameter, the aspect ratio and the CV value of the above mentioned hole are, In the case of disposing the fine particles by sucking, the average hole diameter, the aspect ratio and the CV value in the conditions which fine particles are sucked.

The preferable holes are those of the average hole diameter being 4/5 to 1.3 times of the average particle diameter of the fine particles, the CV value being 5% or less, and the aspect ratio being less than 1.3.

It is preferable that the hole is tapered or step-wise in the thickness direction from the front side to the back side, so that the absorbed particles are more stably disposed and are less to cause deviation.

The average hole diameter of the back side as seeing the hole from the back side is preferably not more than the average hole diameter of the film front side and 50% or more of the film front side. If the average hole diameter of the back side is larger than the average hole diameter of the front side, the disposed particles are ready for deviation or penetrate through the film. If the average hole diameter of the film back side is less than 50% of the average hole diameter of the front side, the disposed particles are ready for deviation.

When the fine particle-disposed film of the invention is used as the conductively connecting film, if the average hole diameter of the film back side is less than 50% of the average hole diameter of the film front side, the particle is difficult to come from the back side and do not reach the electrodes to cause the connection failure . The average hole diameter of the film back side is preferably 70% or more of the average hole diameter of the film front side, more preferably 80% or more, and still more preferably 90 to 95%.

The fine particle-disposed film of the invention may be provided by a method of forming holes in arbitrary positions of the film having substantially no tuck on the front side (a fine particle invading side) when the fine particles are sucked in, sucking fine particles in from the film back side, and disposing fine particles on the surface of the holes or inside the hole. The fine particle disposing method is also one of the inventions.

Incidentally, "having substantiallyno tack" in this description is meant by such a condition where only the not-disposed particles can be moved, when the same magnitude, external forces having components vertical with the thickness direction of the film are loaded to the particles disposed or the particles not disposed in the holes of the film under a condition of at least absorbing particles.

No especial limitation is made to the method of forming holes in the fine particle-disposed film, but a holing process using the laser is desirable. In holing processes mechanically operating by means of a drill or the others, it is difficult to provide a desired dimensional precision, and may take much time for operating. As the hole processing laser, for, example, CO₂ laser, YAG laser, excimer laser or the like may be mentioned. Taking necessary dimensional precision and cost into consideration, a kind of laser to be used is decided.

In the case that the suction of the fine particles is carried out by the air-suction, the degree of vacuum at the sucking side preferably satisfies the following conditions.
(1) In the case that the average particle diameter of the fine particles is 800 to 200 µm, the degree of vacuum is -10 kPa or less.
(2) In the case that the average particle diameter of the fine particles is 200 to 40 µm, the degree of vacuum is -20 kPa or less.
(3) In the case that the average particle diameter of the fine particles is less than 40 µm, the degree of vacuum is -30 kPa or less.

If the degree of vacuum is lower than the above, since the suction is weak, the fine particle is not enough absorbed, and is not disposed in the hole, or even if being disposed, it is easily off from the hole. More preferably, the degree of vacuum is -25 kPa or less (the average particle diameter: 800 to 200 µm), -35 kPa (the average particle diameter: 200 to 40 µm), -45 kPa or less (the average particle diameter: less than 40 µm), and more preferably, -40 kPa or less (the average particle diameter: 800 to 200 µm), -50 kPa or less (the average particle diameter: 200 to 40 µm), and -60 kPa or less (the average particle diameter: less than 40 µm).

When the fine particles are sucked, especially if the film has plasticity, the film itself might be deformed by the suction, and so a suction opening is preferably provided with a support plate on sucking. As the support plate, so far as it does not disturb the suction, no limitation is especially made, for example, such as a mesh is enumerated.

When the fine particle-disposed film is used as the conductively connecting film, extra fine particles adhered to the film generate a short between the neighbor electrodes, and therefore it is desirable to include a step of removing such adhered extra particles by means of an air purge, brush, blade , squeegee and the like. Among them, it is more desirable to remove particles by the brush under a condition of sucking particles.

The fine particle-disposed film is preferably subjected to a light pressing for purpose of making the arrangement more stable. The disposed fine particles are thereby remarkably stabilized and cause no defects owing to such as deviation. Further, for fixing the disposed fine particles, an adhesive or a sealing agent may be coated at the front and back sides of the film.

It is desirable that a center of gravity of the fine particle is present in the film. The center of gravity is present in the film, the particles are more stable in comparison with the center of gravity being present out of the film face, yet causing no defects owing to such as deviation.

Usually, the fine particle is easy to charge and easily causes adhesion or aggregation of particles, and desirably the fine particles are disposed with removing electricity.

The surfaces of the disposed fine particles are desirably exposed on both front and back sides of the film. If the surfaces of the fine particles are exposed on both front and back sides of the film, when the fine particle-disposed film of the invention is used as the conductively connecting film, the connection may be more secured.

Usage of the fine particle-disposed film of the invention is not especially limited, and, for example, an optical film or sensor, switching film, conductively connecting film and the like are enumerated. Among them, with respect to electronic products as a liquid crystal display, a personal computer, or mobile communication machines, in methods of electrically connecting small sized parts, such as a semiconductor element, on a substrate, or electrically connecting substrates each other, the fine particle-disposed film of the invention is suitably used as the conductively connecting film used to connection of the opposite fine electrodes. The above mentioned conductively connecting film is also one of the inventions. In this case, as the fine particle, the conductive fine particle is employed.

The above mentioned substrates are roughly divided into a flexible substrate and a rigid substrate.

The flexible substrate has, for example, thickness of 50 to 500 µm, and uses a resin sheet made of polyimide, polyamide, polyester ,polysulfone, or the like.

The rigid substrate is roughly divided into a resin-made one and a ceramic-made one. The resin-made substrate includes, for example, the one made of a glass fiber reinforced epoxy resin, a phenol resin, a cellulose fiber reinforced phenol resin or the like. The ceramic made substrate is made of, for example, silicon dioxide, alumina or the like.

As the substrate, the rigid substrate is desirable from the viewpoint that the fine particle can be sufficiently pressed against the electrode.

The substrate may have a structure of a single layer, or a multi-layer for increasing the number of electrodes per unit area, for example, the multi-layer substrate being formed a plurality of layers for electric connections one another, such as a means of forming a through-holes.

Parts therefor are not especially limited, for example, enumerated are active parts of semi-conductor such as IC , LSI or the like, capacitors, passive parts such as crystal oscillator, bear chip and the like. The conductively connecting film of the invention is especially suited for connecting bear chips. Further, bumps are required for ordinarily connecting the bear chips by flip chips, but in the case of using the conductively connecting film of the invention, the fine particle serves as the bumps so that a bumpless connection is possible, and a large merit is brought about of being able to save a troublesome step in a bump production.

In the case that the fine particles exist in places other than the electrodes to be disposed on making the bumpless connection, inconveniences occurs as destroying a protecting layer of the chip, but such inconveniences do not occur in the conductively connecting film of the invention. In addition, when the conductive fine particle has a desirable K value or CV values, the electrode easily to be oxidized as an aluminum electrode may be connected by breaking an oxide film.

On the surface of the substrate or parts, the electrodes are formed. No especial limitation is made to shapes of the electrode, and for example, stripe form, dot form, arbitrary form ones and the like may be listed.

Materials of the electrode include gold, silver, copper, nickel, palladium, carbon, aluminum, ITO or the like. For reducing the contacting resistance, such an electrode, in which gold is further coated on the coating of copper, nickel, or the like, may be used.

The thickness of the electrode is preferably 0.1 to 100 µm, and the width is preferably 1 to 500 µm.

Fig. 1 shows one embodiment of the method of producing the conductively connecting film of the invention, and an embodiment of the method of producing the conductively connected structure by using the conductively connecting film.

At first, the film 1 is holed in taper shape by means of the laser. Subsequently, suction openings 3 are applied to the side of smaller hole size of the film 1 so that all the holes formed in the film 1 are covered and an air is not to leak, and the conductive fine particles 2 are absorbed. Thereby, the conductive fine particles 2 are disposed one by one neither more nor less in the holes formed in the film 1.

Next, the conductively connecting film is placed on the substrate 5 provided with the electrodes 6 in the same interval as the holes formed in the film 1 such that the electrodes 6 contact the conductive fine particles 2, and further, IC 4 similarly provided with the electrodes 6 in the same interval as the above is thereon laminated in such a manner that a side formed with the electrode 6 is made under, the electrode 6 contacts the conductive fine particle 2, and the product is heated and pressed. Thus, the conductively connected structure is produced where the substrate 5 and IC 4 are made conductive via the conductively connecting film.

For the above heating and pressing, a press-attaching machine with a heater or the like apparatus is used. In the case that the film itself does not have the adhering property or the curing property, the adhesive may be auxiliarily coated on the film surface, or the like treatment may be applied.

The conductively connected structure of the substrate, parts, or the like connected by means of the conductively connecting film is also one of the invention.

As another use example of the fine particle-disposed film of the invention, the conductive fine particle can be still used for forming the bump. In this case, the bump is produced such that the conductive fine particle of the disposed film of the invention is placed on the electrode of the chip, and fixed with being pressed. In this case, a silver paste or the like may be auxiliary used.

The fine particle-disposed film of the invention can be easily disposed efficiently on arbitrary places of the film neither more nor less under the condition of the fine particles being stable by sucking the specific fine particles from the back side of the film formed with the specific holes, and it is possible to obtain the film stably disposed with the fine particles in the arbitrary places.

In the conductively connecting film of the invention, by using the specific film arbitrarily disposed with the specific conductive fine particle, it is possible to easily obtain the electric connection between opposite fine electrodes with high reliability in a short period of time without leaking from the neighbor electrodes and the connected structure.

### BEST MODE FOR CARRYING OUT THE INVENTION

The invention will be explained with reference to Examples, but is not limited thereto.

### (Example 1)

Methyl methacryl based crosslinking copolymer obtained by suspension polymerization was classified by screening and an air-classification into fine globes of average particle diameter: 150 µm, aspect ratio: 1.05 and CV value: 2%. Further, the polyester film of Young's modulus: 2 GPa, thickness: 150 µm and size: 2 cm x 2 cm was formed with 32 holes to be square shaped at 0.5 mm pitch via the excimer laser, such that the holes of CV value: 3% and aspect ratio: 1.05 would be shaped in taper of 150 µm on the front side and 120 µm on the back side of the film. By using the excimer laser, the desired dimensions and shapes could be precisely formed. At the back side of the film, the suction openings of 7 mm diameter were attached such that all holes of film were covered and any leakage was not to be caused, and fine particles were sucked as the suction opening coming near to fine particles while sucked at the degree of vacuum of -50 kPa. In around several seconds, the particles were disposed in each of holes in the film one by one neither more nor less. Duration of this period, electricity was removed not to adhere fine particles. Fine particles were absorbed to be disposed in the holes, and then the vacuum was released, and the film was held between glass sheets and slightly pressed for making fine particles stable. The center of gravity of the particles was present inside the film, and even if the film was vibrated, particles did not separate from the holes.

### (Example 2)

Fine particles of polystyrene of average diameter: 250 µm, aspect ratio: 1.15 and CV value: 4% were prepared. Further, the polyimide film of Young's modulus: 6 GPa, thickness: 180 µm and size: 2 cm x 2 cm was formed with 32 holes to be square shaped at 0.5 mm pitch via the CO₂ laser, such that the holes of CV value: 6% and aspect ratio: 1.25 would be shaped in taper of 220 µm on the front side and 190 µm on the back side of the film. By using the CO₂ laser, the desired dimensions and shapes could be precisely formed. At the back side of the film, the suction openings of 7 mm diameter were attached such that all holes of film were covered and any leakage was not to be caused, and fine particles were sucked as the suction opening coming near to fine particles while sucked at the degree of vacuum of -30 kPa. Although particles of minute amount escaped to the vacuum side and particles of minute amount were adhered, they could be removed by a slight air purge. Further, although particles of minute amount deviated, other particles were absorbed immediately to recover the holes.

In around several ten seconds, the particles were disposed in each of holes in the film one by one neither more nor less. When fine particles were absorbed to be disposed in the holes, and vacuum was released, the center of gravity of the particles was present out of the film surface, but if the film was not vibrated, particles did not separate from the holes.

### (Example 3)

Divinylbenzene based copolymer obtained by seed polymerization was classified by screening and a wet-classification into fine globes. Then, a nickel layer of 0.2 µm thickness was formed onto the fine gloves by an electroless plating, and further a gold layer of 2.3 µm thickness was formed by an electroplating. Particles thereof were further classified into metal-coated fine globes of average diameter: 75 µm, aspect ratio: 1.03, CV value: 1%, K value: 4000 N/mm², recover rate: 60%, coefficient of linear expansion at normal temperature: 50 ppm, and resistant value: 0.01 Ω. Further, the half-cured epoxy based film of Young's modulus: 0.4 GPa, thickness: 68 µm and size: 1 cm x 1 cm was formed via the CO₂ laser with 18 holes in two rows of about 3 mm-separation at about 300 µm pitches such that the holes would agree in position with the electrodes of IC chips, and formed via the CO₂ laser to be CV value: 2% and aspect ratio: 1.04, and shaped in taper of 75 µm on the front side and 68 µm on the back side of the film. By using the CO₂ laser, the desired dimensions and shapes could be precisely formed. At the back side of the film, the suction openings of 8 mm diameter were attached such that all holes of film were covered and any leakage was not to be caused, and fine particles were sucked as the suction opening coming near to fine particles while sucked at the degree of vacuum of -65 kPa. At this time, the suction opening was furnished with SUS-made mesh of 50µm aperture for supporting the film. In around several seconds, the particles were disposed in each of holes in the film one by one neither more nor less. Duration of this period, electricity was removed not to adhere fine particles. Excessive adhered particles were scarcely seen, but for precaution, the film was swept on the surface with a soft brush to remove extra fine particles as well as foreign matters. Fine particles were absorbed to be disposed in the holes, and then the vacuum was released, and the film was held between glass sheets and slightly pressed for making fine particles stable. The center of gravity of the particles was present in the film, and even if the film was vibrated, particles did not separate from the holes.

The thus obtained conductively connecting film was mounted on FR-4 substrate pictured with electrode patterns, such that the position of the electrode and the position of the conductive fine particle coincided, and after the film was slightly pressed to temporarily attach, the position of the Al electrode of the chip and the position of the conductive fine particle were coincided, and were heated to adhere, and epoxy resin was cured to make a flip-chip bonding. The coefficient of linear expansion of the cured epoxy resin at normal temperature was 50 ppm.

The thus connected structure was stably conductive in all electrodes, and worked as normally since no leakage occurred in the neighbor electrodes. Heating cycle tests were made 1000 times at -25 to 100°C, and no abnormality was seen in the resistant value-up or actuation in connected parts even at lower and higher temperatures.

Impact tests were carried out, and there were not such cases of picking up noises or instantaneous disconnection.

Observing a contact face between the electrode at the chip side and the conductive fine particle, a touch area was almost equal in each portion, and no thin film resin was penetrated into parts of the contact faces.

### (Example 4)

On the fine globes of the methyl methacryl based cross-linking copolymer, the nickel layer of 0.1 µm thickness was formed by an electroless plating, and further a gold layer of 0.9 µm thickness was formed by an electroplating. Particles thereof were classified into metal-coated fine globes of average diameter: 45 µm, aspect ratio: 1.05, CV value: 2%, K value: 2000 N/mm², recover rate: 50%, coefficient of linear expansion at normal temperature: 80 ppm, and resistant value: 0.03 Q. Further, the half-cured glass-epoxy based film of Young's modulus: 2 GPa, thickness: 60 µm and size: 1 cm x 1 cm was formed via the excimer laser with 16 holes in two rows of about 2 mm-separation at 150 µm pitches, such that the holes would agree in position with the electrodes of IC chips, formed via the excimer laser to be CV value: 2% and aspect ratio: 1.05, and shaped in taper of 43 µm on the front side and 38 µm on the back side of the film. By using the excimer laser, the desired dimensions and shapes could be precisely formed. At the back side of the film, the suction openings of 5 mm diameter were attached such that all holes of film were covered and any leakage was not to be caused, and fine particles were sucked as the suction opening coming near to fine particles while sucked at the degree of vacuum of -65 kPa. In around several seconds, the particles were disposed in each of holes in the film one by one neither more nor less. Duration of this period, electricity was removed not to adhere fine particles. Excessive adhered particles were scarcely seen, but for precaution, the film was swept on the surface with a soft brush to remove extra fine particles as well as foreign matters. Fine particles were absorbed to be disposed in the holes, and then the vacuum was released, and the film was held between glass sheets and slightly pressed for making fine particles stable. The center of gravity of the particles was present in the film, and even if the film was vibrated, particles did not separate from the holes.

The thus obtained conductively connecting film was mounted on the ceramic substrate pictured with electrode patterns, such that the position of the electrode and the position of the conductive fine particle were coincided, and after the film was slightly pressed and heated to temporarily attach, the position of the gold electrode of the chip having the gold bump of around 20 µm and the position of the conductive fine particle were coincided, and were pressed and heated to adhere, and epoxy resin was cured to make a flip-chip bonding. The coefficient of linear expansion of the cured glass-epoxy at normal temperature was 30 ppm.

The thus connected structure was stably conductive in all electrodes, and worked as normally since no leakage occurred in the neighbor electrodes. Heating cycle tests were made 1000 times at -25 to 100°C, and no abnormality was seen in the resistant value-up or actuation in connected parts even at lower and higher temperatures.

Impact tests were carried out, and there were not such cases of picking up noises or instantaneous disconnection.

Observing a contact face between the electrode at the chip side and the conductive fine particle, a touch area was almost equal in each portion, and no thin film resin was penetrated into parts of the contact faces.

### (Example 5)

On the fine globes of the bridged epoxy resin particles, the nickel layer of 0.4 µm thickness was formed by an electroless plating, and further a gold layer of 0.1 µm thickness was formed by the electroless substitution plating. Particles thereof were classified into metal-coated fine globes of average diameter: 200 µm, aspect ratio: 1.1, CV value: 2%, K value: 3000 N/mm², recover rate: 70%, coefficient of linear expansion at normal temperature: 60 ppm, and resistant value: 0.3 Ω. Further, the half-cured epoxy based film of Young's modulus: 0.8 GPa, thickness: 170 µm and size: 2 cm x 2 cm was formed to be square with 32 holes at 0.5 mm pitch, formed via the drill to be CV value: 3% and aspect ratio: 1.2, and shaped in step-wise form of 230 µm on the front side and 150 µm on the back side of the film.

At the back side of the film, the suction openings of 7 mm diameter were attached such that all holes of film were covered and any leakage was not to be caused, and fine particles were sucked as the suction opening coming near to fine particles while sucked at the degree of vacuum of -40 kPa. In around ten and several seconds, the particles were disposed in each of holes in the film one by one neither more nor less . Duration of this period, electricity was removed not to adhere fine particles. Excessive adhered particles were very rarely seen around the holes, but could be easily removed by sweeping on the film surface with the soft brush. Fine particles were absorbed to be disposed in the holes, and then the vacuum was released, and the film was held between glass sheets and slightly pressed for making fine particles stable. The center of gravity of the particles was present in the film, and even if the film was vibrated, particles did not separate from the holes.

The thus obtained conductively connecting film was mounted on FR-4 substrate pictured with electrode patterns, such that the position of the electrode and the position of the conductive fine particle were coincided, and after the film was slightly pressed and heated to temporarily attach, the agreement was performed between the positions of the electrodes of ceramic dummy chips furnished with 32 piece-electrodes to be square at 0.5 mm pitch and the positions of the conductive fine particle coincided, and the products were pressed and heated to adhere, and epoxy resin was cured to make the flip-chip bonding. The coefficient of linear expansion of the cured epoxy resin at normal temperature was 80 ppm.

As to the thus connected structure, the conductive resistance was more or less high, but all were exactly conductive. When the heating cycle tests were made 1000 times at -25 to 100°C, the resistance somewhat went up with no matter, and the resistant value-up was scarcely seen in connected parts at lower and higher temperatures.

Impact tests were carried out, and there were not such cases of picking up noises or instantaneous disconnection.

Observing a contact face between the electrode at the chip side and the conductive fine particle, though the touch areas were different depending on particles, and no thin film resin was penetrated into parts of the contact faces.

### (Example 6)

On the fine globes of silica in substitution of the epoxy resin particles in Example 5, the nickel layer of 0.4 µm thickness was formed by an electroless plating, and further a gold layer of 0.1 µm thickness was formed by the electroless substitution plating. Particles thereof were classified into metal-coated fine globes of average diameter: 200 µm, aspect ratio: 1.1, CV value: 2%, K value: 16000 N/mm², recover rate: 95%, coefficient of linear expansion at normal temperature: 10 ppm, and resistant value: 0.3 Ω.

By means of the conductively connecting film using the fine globes, the flip-chip bonding was made as Example 5.

As to the thus connected structure, the conductive resistance was more or less high, but all were exactly conductive. When the heating cycle tests were made 1000 times at -25 to 100°C, the resistance increased with no problem. Although the structure was more or less unstable in conduction at high temperatures, or picked up somewhat noises and the like, there were elements sufficiently usable.

Observing a contact face between the electrode at the chip side and the conductive fine particle, though the touch areas were different depending on particles, and no thin film resin was penetrated into parts of the contact faces.

### (Example 7)

On the fine globes of non-bridged acrylic in substitution of the epoxy resin particles in Example 5, the nickel layer of 0.4 µm thickness was formed by an electroless plating, and further a gold layer of 0.1 µm thickness was formed by the electroless substitution plating. Particles thereof were classified into metal-coated fine globes of average diameter: 200 µm, aspect ratio: 1.1, CV value: 2%, K value: 200N/mm², recover rate: 4%, coefficient of linear expansion at normal temperature: 150 ppm, and resistant value: 0.3 Ω.

By means of the conductively connecting film using the fine globes, the flip-chip bonding was made as Example 5.

As to the thus connected structure, the conductive resistance was more or less high, but all were exactly conductive. When the heating cycle tests were made 1000 times at -25 to 100°C, the resistance increased with no problem. Although the structure was more or less unstable in conduction at lower temperatures, or picked up somewhat noises and the like, there were elements sufficiently usable.

Observing a contact face between the electrode at the chip side and the conductive fine particle, though the touch areas were different depending on particles, and no thin film resin was penetrated into parts of the contact faces.

### (Example 8)

Particles were absorbed similarly in Example 5 excepting use of the ceramic film of the Young's modulus being 20 GPa in place of epoxy film in Example 5, and some particles were observed which were once placed in the holes but sprung off by a vibration impact when being sucked, and it took excessive time for disposing particles. Small damages or exfoliation were seen in parts of coated metals on the disposed particles, but they had practically no matter.

### (Example 9)

Divinylbenzene based copolymer obtained by seed polymerization was classified by screening and a wet-classification into fine globes. Then, a nickel layer of 0.2 µm thickness was formed by an electroless plating, and further a gold layer of 1.8 µm thickness was formed by an electroplating. Particles thereof were classified into metal-coated fine globes of average diameter: 75 µm, aspect ratio: 1.03, CV value: 1%, K value: 3800 N/mm², recover rate: 60%, coefficient of linear expansion at normal temperature: 50 ppm, and resistant value: 0.01 Q. Observing the thus obtained conductive fine particles, peeling of the metal-coated film or the other defect was not seen.

Further, the half-cured epoxy based film of Young's modulus: 0.4 GPa, thickness: 68 µm and size: 1 cm x 1 cm was formed via the CO₂ laser with 18 holes in two rows of about 3 mm-separation at about 300 µm pitches, such that the holes would agree in position with the electrodes of IC chips, formed via the CO₂ laser to be CV value: 2% and aspect ratio: 1.04, and shaped in taper of 75 µm on the front side and 68 µm on the back side of the film. By using the CO₂ laser, the desired dimensions and shapes could be precisely formed. At the back side of the film, the suction openings of 8 mm diameter were attached such that all holes of film were covered and any leakage was not to be caused, and fine particles were absorbed as the suction opening coming near to fine particles with absorbing at the degree of vacuum of -65 kPa. At this time, the suction opening was furnished with SUS-made mesh of 50µm aperture for supporting the film. In around several seconds, the particles were disposed in each of holes in the film one by one neither more nor less. Duration of this period, electricity was removed not to adhere fine particles. Excessive adhered particles were scarcely seen, but for precaution, the film was swept on the surface with a soft brush to remove extra fine particles as well as foreign matters . Fine particles were absorbed to be disposed in the holes, and then the vacuum was released, and the film was held between glass sheets and slightly pressed for making fine particles stable. The center of gravity of the particles was present in the film, and even if the film was vibrated, particles did not separate from the holes.

The thus obtained conductively connecting film was mounted on FR-4 substrate pictured with electrode patterns, such that the position of the electrode and the position of the conductive fine particle were coincided, and after the film was slightly pressed to temporarily attach, the position of the Al electrode of the chip and the position of the conductive fine particle were coincided, and the products were heated and pressed to adhere, and epoxy resin was cured to make a flip-chip bonding. The coefficient of linear expansion of the cured epoxy resin at normal temperature was 50 ppm. Observing the conductive fine particles after heating and press-attaching, peeling of the metal-coated film or the other defect was not seen.

The thus connected structure was stably conductive in all electrodes, and worked as normally since no leakage occurred in the neighbor electrodes. Heating cycle tests were made 1000 times at -25 to 100°C, and no abnormality was seen in the resistant value-up or actuation in connected parts even at lower and higher temperatures.

Impact tests were carried out, and there were not such cases of picking up noises or instantaneous disconnection.

Observing a contact face between the electrode at the chip side and the conductive fine particle, a touch area was almost equal in each of portion, and no thin film resin was penetrated into parts of the contact faces.

### (Comparative Example 1)

Similar to in Example 1, excepting use of the fine globes of the aspect ratio being 1.5 and the CV value being 15%, the production of the fine particle-disposed film was tried. However, many particles escaped to the vacuum side when being sucked, some holes were clogged with more than two particles in one hole, and flat or large particles were once absorbed and disposed, but deviated at the time of releasing vacuum.

### (Comparative Example 2)

Similar to Example 1, excepting the hole diameter in the film front side being 70 µm and the hole diameter in the back side being 50 µm, the production of the fine particle-disposed film was tried. However, although once absorbed and disposed, some particles were deviated even at the condition of being sucked, and almost all particles were off from the holes at the time of releasing vacuum.

### (Comparative Example 3)

Similar to Example 1, excepting the hole diameter in the film front side being 310 µm and that in the back side being 250 µm, the production of the fine particle-disposed film was tried. However, particles escaped to the vacuum side, and could not be disposed.

### (Comparative Example 4)

Similar to Example 1, excepting the hole in the film front side being the aspect ratio being 2 and the CV value being 25%, the production of the fine particle-disposed film was tried. However, many particles escaped to the vacuum side when being sucked, some holes were clogged with more than two particles in one hole, and although once absorbed and disposed, particles were deviated at the time of releasing vacuum.

### (Comparative Example 5)

Similarly in Example 1, fine particles of methyl methacryl based crosslinked copolymer of average diameter being about 4 µm were absorbed in the film of polyester formed holes of around 3 to 4 µm, but many particles were adhered owing to static electricity and the like and could not properly disposed.

### (Comparative Example 6)

Similar to Example 3, excepting use of ACF produced by being at random dispersed the metal coated fine globes in epoxy based film, the flip-chip bonding was intended to make but there occurred electrodes which were not conductive if the conductive fine particles were few. Gradually increasing the conductive fine particles, some parts were generated where the neighbor electrodes leaked. Further, when large particles came to parts other than electrodes of the chip, load was concentrated to the parts and a phenomenon was seen which broke the protective film of the chip.

Thereby, it was seen that, as far as using the conductive fine particles of at least similar size, the disposed particles were apparently responsible to fine pitches. Also as to parts being conductive, it was observed that the thin film resins were penetrated in parts of the contact faces with the electrodes.

### (Comparative Example 7)

In Example 4, making the conductively connecting film using fine globes of the aspect ratio being 1.5 and the CV value being 12%, and carrying out the flip-chip bonding with this film similarly in Example 4, electrode parts, which were non-conductive though the hot pressing condition were altered, were much generated.

### (Comparative Example 8)

In Example 3, the conductively connecting film was produced where the nickel layer of 0.1 µm thickness was formed by the electroless plating, and further the gold layer of 0.1 µm thickness was formed by the electroplating, and the flip-chip bonding was carried out using this conductively connecting film similarly in Example 3, but the metal coating layer was destroyed, and electrode parts, which were non-conductive, were much generated.

### INDUSTRIAL APPLICABILITY

The invention is based on the above mentioned construction, and specific fine particles are sucked from the back side of the film formed with specific holes, so that the fine particles may be disposed easily and efficiently in arbitrary positions in the film under a stable condition, and the film stably disposed with fine particles in arbitrary position may be produced. Further, according to the invention, by using the specific film arbitrarily disposed with the specific conductive fine particles, it is possible to easily obtain the electric connection of the fine opposite electrodes with a high reliability, in a short period of time and without a leakage in neighbor electrodes, and the connected structure.

## Claims

1. A fine particle-disposed film, in which fine particles are disposed, the fine particles each having:
an average particle diameter of 5 to 800 µm;
an aspect ratio of less than 1.5; and
CV value of 10% or less,
wherein the film has holes at arbitrary positions in a surface thereof, the holes each having: an average hole diameter which is 1/2 to 2 times of the average particle diameter of the fine particle; the aspect ratio of less than 2; and the CV value of 20% or less, and
the fine particles are disposed on the surface of the holes or inside the holes.

2. The fine particle-disposed film as described in claim 1, wherein the surfaces of the fine particles are exposed at both front and back sides of the film.

3. The fine particle-disposed film as described in claim 1 or 2, wherein the fine particle is a spherical particle having: an average particle diameter of 20 to 150 µm; an aspect ratio of less than 1.1; and a CV value of 2% or less.

4. The fine particle-disposed film as described in claim 1, 2 or 3, wherein a core of the fine particle is a high-molecular-weight material.

5. The fine particle-disposed film as described in claim 1, 2, 3 or 4, wherein the fine particle has: K value of 400 to 15000 N/mm²; a recovery rate of 5% or more; and a coefficient of linear expansion at normal temperature of 10 to 200 ppm.

6. The fine particle-disposed film as described in claim 1, 2, 3, 4 or 5, wherein the fine particle has: K value of 2000 to 8000 N/mm²; a recovery rate of 50% or more; and coefficient of linear expansion at normal temperature of 30 to 100 ppm.

7. The fine particle-disposed film as described in claim 1, 2, 3, 4, 5 or 6, wherein the fine particle has a metal coating layer.

8. The fine particle-disposed film as described in claim 7, wherein the thickness of the metal coating layer is 0.3 µm or more.

9. The fine particle-disposed film as described in claim 7 or 8, wherein the metal includes nickel or gold.

10. The fine particle-disposed film as described in claim 1, 2, 3, 4, 5, 6, 7, 8 or 9, wherein the fine particle has a resistance value of 3 Ω or less.

11. The fine particle-disposed film as described in claim 1, 2, 3, 4, 5, 6, 7, 8, 9 or 10, wherein the fine particle has a resistance value of 0.05 Ω or less.

12. The fine particle-disposed film as described in claim 1, 2, 3, 4, 5, 6, 7, 8, 9, 10 or 11, wherein the thickness of the film is 1/2 to 2 times of the average particle diameter of the fine particle.

13. The fine particle-disposed film as described in claim 1, 2, 3, 4, 5, 6, 7, 8, 9, 10, 11 or 12, wherein the thickness of the film is 3/4 to 1.3 times of the average particle diameter of the fine particle.

14. The fine particle-disposed film as described in claim 1, 2, 3, 4, 5, 6, 7, 8, 9, 10, 11, 12 or 13,
wherein a Young's modulus of a surface of the film is 10 GPa or less.

15. The fine particle-disposed film as described in claim 1, 2, 3, 4, 5, 6, 7, 8, 9, 10, 11, 12, 13 or 14, wherein the film become adhesive by pressing or heating.

16. The fine particle-disposed film as described in claim 1, 2, 3, 4, 5, 6, 7, 8, 9, 10, 11, 12, 13, 14 or 15, wherein the film is cured by heating or UV irradiation.

17. The fine particle-disposed film as described in claim 1, 2, 3, 4, 5, 6, 7, 8, 9, 10, 11, 12, 13, 14, 15 or 16, wherein a coefficient of linear expansion after curing of the film is 10 to 200 ppm.

18. The fine particle-disposed film as described in claim 1, 2, 3, 4, 5, 6, 7, 8, 9, 10, 11, 12, 13, 14, 15, 16 or 17, wherein the average hole diameter in the front side of the hole is 4/5 to 1.3 times of the average particle diameter of the fine particle, the CV value of the hole is 5% or less, and the aspect ratio of the hole is less than 1.3.

19. The fine particle-disposed film as described in claim 1, 2, 3, 4, 5, 6, 7, 8, 9, 10, 11, 12, 13, 14, 15, 16, 17 or 18, wherein the hole is tapered or step-wise in the thickness direction.

20. The fine particle-disposed film as described in claim 1, 2, 3, 4, 5, 6, 7, 8, 9, 10, 11, 12, 13, 14, 15, 16, 17, 18 or 19, wherein the average hole diameter in the back side of the film is not more than the average hole diameter in the front side of the film, and is 50% or more of the average hole diameter in the front side of the film.

21. The fine particle-disposed film as described in claim 1, 2, 3, 4, 5, 6, 7, 8, 9, 10, 11, 12, 13, 14, 15, 16, 17, 18, 19 or 20, wherein the average hole diameter in the back side of the film is not more than the average hole diameter in the front side of the film, and is 80% or more of the average hole diameter in the front side of the film.

22. The fine particle-disposed film as described in claim 1, 2, 3, 4, 5, 6, 7, 8, 9, 10, 11, 12, 13, 14, 15, 16, 17, 18, 19, 20 or 21, wherein a processing for making the hole is performed by a laser.

23. A conductively connecting film that is the fine particle-disposed film as described in claim 1, 2, 3, 4, 5, 6, 7, 8, 9, 10, 11, 12, 13, 14, 15, 16, 17, 18, 19, 20, 21 or 22, wherein the fine particles are conductive fine particles.

24. A conductively connected structure, wherein a connection is performed by using the conductively connecting film as described in claim 23.

25. Amethod for disposing fine particles, in which the fine particles are disposed in a film as the fine particle-disposed film as described in claim 1, 2, 3, 4, 5, 6, 7, 8, 9, 10, 11, 12, 13, 14, 15, 16, 17, 18, 19, 20, 21 or 22,
wherein the fine particles are sucked from the back side of the film, the back side having substantially no tack on the surface.

26. The method for disposing fine particles as described in claim 25, wherein the suction of the fine particles is carried out by a suction of gas,
when the average particle diameter of the fine particles is 800 to 200 µm, a degree of vacuum in the suction side is -10 kPa or less,
when the average particle diameter of the fine particles is 200 to 40 µm, a degree of vacuum in the suction side is -20 kPa or less, and
when the average particle diameter of the fine particles is less than 40 µm, a degree of vacuum in the suction side is -30 kPa or less.

27. The method for disposing fine particles as described in claim 25 or 26, wherein a support plate is provided at a suction opening when the fine particles are sucked in.

28. The method for disposing fine particles as described in claim 25, 26,or 27, which comprises a step of removing extra adhering particles by an air purge or brush.

29. The method for disposing fine particles as described in claim 25, 26, 27 or 28, which comprises a step of pressing the fine particle-disposed film.

30. The method for disposing fine particles as described in claim 25, 26, 27, 28 or 29, wherein a center of gravity of the fine particle resides inside the film.

31. The method for disposing fine particles as described in claim 25, 26, 27, 28, 29 or 30, wherein the fine particles are disposed with electricity being removed.
